# EUROPEAN PATENT APPLICATION

(11) **EP 4 443 237 A1**
(43) Date of publication of application: **09.10.2024**
(21) Application number: 23166309.7
(22) Date of filing: 03.04.2023
(51) Int. Cl.: G03F 7/00, F01N 1/00, F01N 1/02, F16L 55/033

(54) **SILENCER AND LITHOGRAPHIC APPARATUS THERMAL CONDITIONING SYSTEM**

(71) Applicant: ASML Netherlands B.V., 5500 AH Veldhoven (NL)
(72) Inventor: REZAEIHA, Abdolrahim, 5500 AH Veldhoven (NL); HUANG, Zhuangxiong, 5500 AH Veldhoven (NL); JACOBS, Johannes, Henricus, Wilhelmus, 5500 AH Veldhoven (NL); FEIJTS, Maurice, Wilhelmus, Leonardus, Hendricus, 5500 AH Veldhoven (NL)
(74) Representative: ASML Netherlands B.V.

(57) **Abstract**

A silencer is configured to silence an acoustic wave in a thermal conditioning fluid at a target frequency. The silencer comprises an open inlet to be connected to a thermal conditioning fluid duct to be in fluid communication with the thermal conditioning fluid in the duct, a closed end to reflect the acoustic wave in the thermal conditioning fluid, and a silencer duct forming a thermal conditioning fluid passage therebetween. The silencer is configured to silence the acoustic wave.

The silencer duct comprises a three dimensional shape configured to provide at least one revolution in the thermal conditioning fluid passage The silencer duct comprises a viscoelastic material.

## Description

### FIELD

The present invention relates to a silencer, a thermal conditioning system comprising such a silencer, a lithographic apparatus comprising such thermal conditioning system, and a method of thermally conditioning an object of a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Objects of the lithographic apparatus may be provided with a thermal conditioning system, which comprises a fluid duct for guiding a thermal conditioning fluid. The fluid duct is configured to guide the thermal conditioning fluid to the object that is to be thermally conditioned, through the object and to discharge the thermal conditioning fluid from the object. The object may for example be a projection system mirror of a projection system of the lithographic apparatus or may for example be a stage, such as a wafer table of the lithographic apparatus. It has been observed that the thermal conditioning duct may guide disturbances, such as vibrations, to the object. This may be undesirable, as such disturbances may result in e.g. a vibration or other movement of the object. It has been suggested to provide the thermal conditioning duct with a silencer which may provide a compliance in order to suppress the disturbance. A movement of the object, such as a mirror or a substrate table of the lithographic apparatus may result in an inaccuracy in the imaging of a pattern on the substate. The inaccuracy may translate into an overlay error which may adversely affect an accuracy of the lithographic apparatus.

### SUMMARY

It is desired to provide a lithographic apparatus having a high overlay accuracy. According to an aspect of the invention, there is provided a silencer configured to silence an acoustic wave in a thermal conditioning fluid in a thermal conditioning fluid duct, the silencer comprising
an open inlet configured to be connected to the thermal conditioning fluid duct to be in fluid communication with the thermal conditioning fluid in the thermal conditioning fluid duct,
a closed end configured to reflect the acoustic wave in the thermal conditioning fluid, and
a silencer duct forming a thermal conditioning fluid passage between the open inlet and the closed end,
wherein the silencer duct has a three dimensional shape configured to provide at least one revolution in the thermal conditioning fluid passage,

wherein the silencer is configured to silence the acoustic wave at a target frequency, and
wherein the silencer duct comprises a viscoelastic material.

According to another aspect of the invention, there is provided a thermal conditioning system configured to thermally condition an object, wherein the thermal conditioning system comprises a thermal conditioning fluid duct configured to be connected to the object and configured to provide a flow of the thermal conditioning fluid to the object, wherein the thermal conditioning fluid duct comprises at least one silencer according to the invention.

According to yet another aspect of the invention, there is provided a lithographic apparatus comprising an object and a thermal conditioning system according to the invention.

According to a still further aspect of the invention, there is provided a method of thermally conditioning an object of a lithographic apparatus, comprising providing a flow of a thermal conditioning fluid via a thermal conditioning fluid duct to the object, the method comprising silencing an acoustic vibration in the thermal conditioning fluid by a silencer according to the invention.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2A and 2B depicts a highly schematic view of a part of a thermal conditioning system with silencers as may be employed in the invention;
   Figure 3A - 3B depict frequency response diagrams based on which an effect of the silencers will be explained;
- Figure 4A - 4C depict highly schematic views of embodiments of a silencer;
- Figure 5 depicts a highly schematic view of an embodiment of a silencer;
- Figure 6A - 6C depict views of silencers according to embodiments of the invention;
- Figure 7A and 7B depict alternative three-dimensional shapes as may be used in the silencer according to the invention.

### DETAILED DESCRIPTION

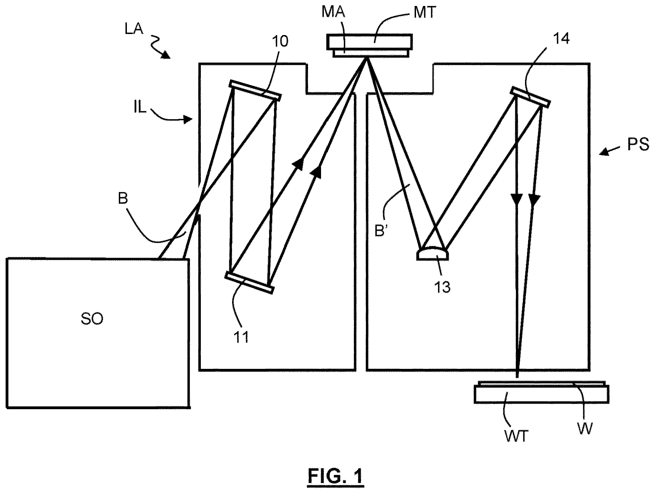

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

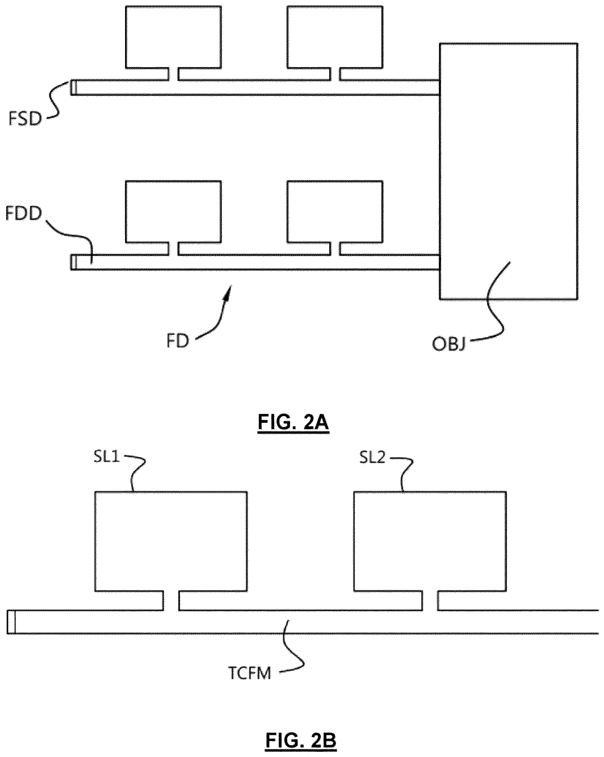

Figure 2A depicts a highly schematic view of a thermal conditioning system which comprises a fluid duct FD connected to an object OBJ. The thermal conditioning system is configured to thermally condition the object. The fluid duct comprises a thermal conditioning fluid supply duct FSD to supply a thermal conditioning fluid to the object OBJ and a thermal conditioning fluid discharging duct FDD, to discharge the thermal conditioning fluid from the object OBJ. The fluid duct may form a fluid flow passage in or on the object, e.g. a fluid channel in the object or a fluid duct on the object, e.g. at a rear side of the object. The thermal conditioning fluid may be formed by any suitable fluid, such as a liquid, e.g. water or a gas. The thermal conditioning system may be configured to heat the object, to cool the object, thereby to provide that the object is stabilized at a desired temperature or within a desired temperature range. The object may for example be a mirror of a lithographic apparatus projection system or a stage, such as a wafer table of a lithographic apparatus. The thermal conditioning fluid may be supplied by any suitable supply means, such as a pump, a pressurizing means, etc.

Figure 2B depicts a schematic view of a part of the fluid supply duct of the thermal conditioning system in accordance with Figure 2A. According to an aspect of the present invention, the fluid supply duct and the fluid discharging duct are each provided with two silencers SL. The silencers may be understood as elements with a low hydraulic stiffness compared to a hydraulic stiffness of the thermal conditioning duct. The hydraulic stiffness may be understood as a ratio of increment in pressure relative to an increment in displaced volume of fluid, K_hyd=dp/dV, wherein p is an absolute pressure, V is a volume of gas.

A silencer as such has been observed to provide a attenuation to suppress disturbances. A silencer as such may provide a suppression of disturbances by e.g. a factor of 10 to a factor of 30. The inventors have however devised that a substantially higher suppression of disturbances may be achieved making use of such a silencer, which suppression may be orders of magnitude higher as compared to the known suppression by a factor of e.g. 10 to 30.

Reverting to Figure 2B, as explained above, at least two silencers are provided in the supply duct and at least two silencers are provided in the return duct. The silencers SL1, SL2 are arranged in series along the supply duct as well as along the discharging duct. Thus, along the supply duct, one of the at least two silencers is upstream in respect of the other one of the at least two silencers. Similarly, along the discharging duct, one of the at least two silencers is upstream in respect of the other one of the at least two silencers. The thermal conditioning fluid between the silencers SL1, SL2 provides for a thermal conditioning fluid mass TCFM.

The inventors have devised that the assembly of the two silencers in series with the thermal conditioning fluid in the duct between the silencers forming the thermal conditioning fluid mass, may provide a resonance behavior resulting in a roll off above the resonance frequency. By dimensioning the silencers, the compliance thereof and the thermal conditioning fluid mass between the silencers, the resonance frequency may be determined to be below a disturbance frequency band, hence enabling to more effectively suppress disturbances in the disturbance frequency band from being transferred via the fluid duct to the object.

Multiple silencers in series are provided with a capability to be effective up to higher frequencies (e.g. above 80Hz). Using at least two silencers in series, a gas volume of each silencer effectively creates a low-stiffness in the water circuit by generating a low hydraulic stiffness (K_hyd=dp/dV). Subsequently, the hydraulic stiffness of a gas volume can be derived to be K_hyd=yp/V (adiabatic conditions). In the above formulas, γ (gamma) is an adiabatic index, p is an absolute pressure, V is a volume of gas. By placing two silencers in series the mass in-between the silencers may start to resonate at a resonance frequency. Below this frequency there may be no additional benefit of multiple silencers, at this frequency there may be an amplification, however, above this frequency the mass in-between the silencers may start to decouple and effectively a -2 slope is gained. This is analogous with a mechanical mass-spring isolation system. In this way a significantly higher suppression may be reached by placing multiple silencers in series. Additionally by either decreasing the stiffness of the silencer (decreasing pressure or increasing gas volume) or increasing the hydraulic mass of the duct between the silencers M_(hyd duct)=ρL/A (increasing the length or decreasing the duct cross sectional area), this resonance frequency may be lowered, such that a higher reduction is achieved (especially relevant around the above mentioned frequency, e.g. 80Hz). Placing more than 2 silencers in series may be applied to create multiple masses in-between silencers that start to decouple, such that effectively a -4 slope or even higher may be reached. Tuning the stiffness of the silencer and the hydraulic mass of the duct between the silencers allows to effectively avoid amplification of resonances and to gain ultimo silencing performance. Placing multiple silencers in series with a sufficient distance in-between is currently the critical technology breakthrough for the introduction of DCM from a dynamics perspective.

Effectivity up to higher frequencies: The distance between the gas volume and the duct may limit the frequency up to which effective use of the gas volume may be obtained. This duct part is referred to as the neck of the silencer and the associated resonance frequency may be referred to as the Helmholtz frequency f_HR. Below this frequency the gas volume is effectively felt, at this frequency an additional suppression may be reached (low effort needed to compress gas volume) and above this frequency the gas volume is not effectively felt anymore. By either increasing the stiffness of the silencer (increasing pressure or decreasing gas volume) or decreasing the hydraulic mass of the neck of the silencers (decreasing the length or increasing the neck diameter), this resonance frequency may be increased, such that the gas volume is effectively felt for higher frequencies (especially relevant around 80Hz). To eliminate the risk of gas being dissolved over time a compliant interface is added. The requirement for this interface is that its stiffness is sufficiently low such that the sum of both the gas volume stiffness and that of the compliant interface still may still meet requirements. In addition the inertia of the bellow may be small enough such that the Helmholtz frequency may stay sufficiently high. Finally the structural resonance of the compliant interface may be sufficiently high, at least higher than the Helmholtz frequency, such that it doesn't deteriorate acoustic silencing performance.

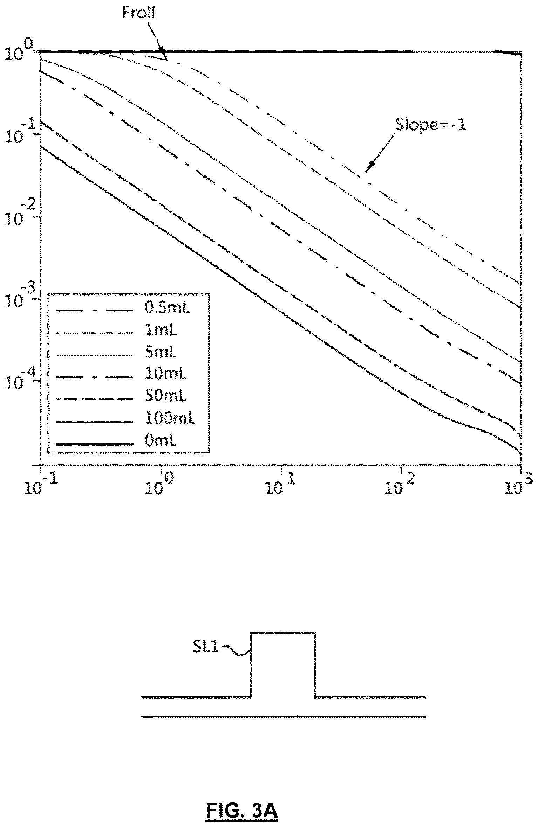

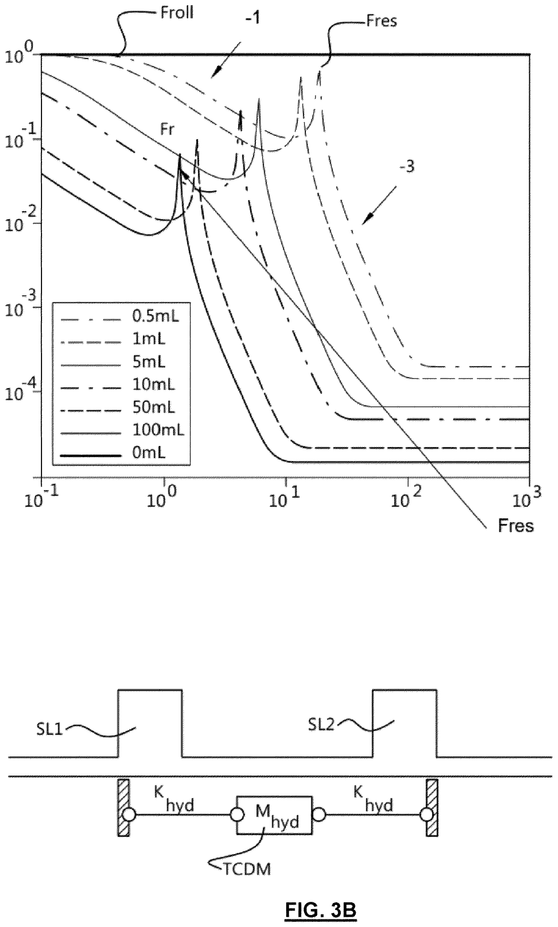

Figure 3A and 3B depicts diagrams where a transfer of a disturbance via the duct to the object is depicted on the vertical axis versus frequency on the horizontal axis. As depicted in Figure 3A, a single silencer in the supply duct FSD and in the return duct FRD provides, above a roll-off frequency Froll, a roll off of a factor 2 per octave, i.e. a factor 10 per frequency decade. As depicted in Figure 3B, two silencers in series in the supply duct and in the return duct may provide for a roll off of a factor 2 per octave from a roll of frequency Froll to a resonance frequency Fres, while providing a triple roll off, i.e. a roll off of a factor 8 per octave above the resonance frequency. The resonance frequency Fres may be determined by the resonance of the dual silencers with the mass of the thermal conditioning fluid in the duct between the two silencers.

Thus, as follows from the above, a single silencer in combination with a non-reflective acoustic boundary condition (critically damped), may provide a -1 slope, i.e. a factor 10 per frequency decade. Dual silencers in series may provide a -3 slope, i.e. a factor 1000 per frequency decade (-1 slope, i.e. the factor 10 per frequency decade may stem from the silencer in combination with a non-reflective acoustic boundary condition, -2 slope, i.e. a factor 100 per frequency decade, may stem from the decoupled mass in between the silencers).

In an embodiment, the at least two silencers form a resonator with the thermal conditioning fluid in the fluid duct interconnecting the at least two silencers. The thermal conditioning fluid in the duct interconnecting the at least two silencers in the supply duct respectively in the return duct, provides for a mass, while the silencers provide for a compliance. The mass of the thermal conditioning fluid between the silencers and the compliance of the silencers may exhibit a resonance behavior, as shown in Figure 3B by the resonance frequency Fres. A resonance behavior implies that two poles are involved in the frequency behavior, as a result if which, above the resonance frequency, a (further) roll off a factor 4 per octave is observed, i.e. a (further) factor 100 per frequency decade. In combination with the roll of the silencer in combination with the non-reflective acoustic boundary condition, a total of a factor 1000 per frequency decade is observed. The resonance frequency may be a resonance due to sloshing of the fluid in the duct between the silencers.

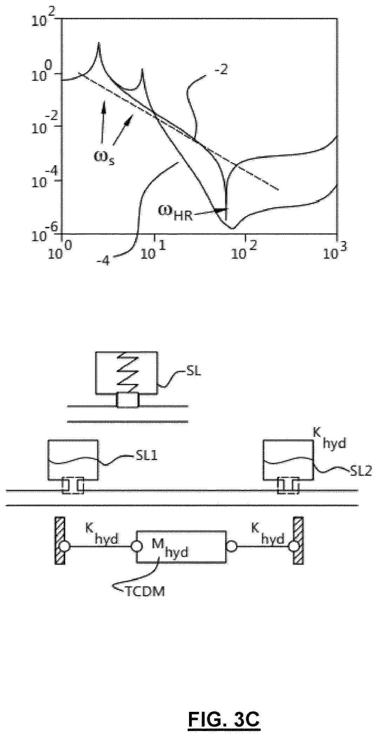

Figure 3C depicts a frequency diagram wherein a transfer of a disturbance via the duct to the object is depicted on the vertical axis versus frequency on the horizontal axis. As depicted in Figure 3C, a single silencer SL as such, in e.g. the supply duct and/or in the return duct, provides a Helmholz resonance at a Helmholz resonance frequency dip ω_{HR} at a square root of a quotient of the hydraulic compliance of the silencer and a hydraulic mass in a silencer fluid conduit, ω_{HR =} √ (K_{Hyd}/M_{Hyd}), wherein ω_{HR} is the Helmholz resonance frequency, K_{Hyd} is the hydraulic compliance of the silencer and M_{Hyd} is the hydraulic mass in the silencer fluid conduit. The Helmholz resonance frequency dip ω_{HR} involves a roll off at a -2 slope. As further depicted in Figure 3C, two silencers in series, e.g. in the supply duct and/or in the return duct, may provide for a resonance peak at a sloshing frequency, the sloshing resonance frequency being equal to a square root of a quotient of [ two times the hydraulic compliance of the silencers and a hydraulic mass in the duct between the two silencers ], ω_{S =}√ (2K_{Hyd}/M_{Hyd}).wherein ω_{S} is the sloshing frequency, 2K_{Hyd} is two times the hydraulic compliance of the silencers and M_{Hyd} is the hydraulic mass in the duct between the silencers. Thus, a silencer pair decouples the hydraulic mass in-between silencers (low stiffness element) achieving a -40 dB/ decade suppression in transfer of pressure over force input (-2 slope) above the sloshing resonance frequency. Multiple silencer pairs (N) allows to benefit from a multitude of decoupled masses resulting into a Nx -40dB/dec. For example, as depicted in Figure 3C, dual pairs provide for two sloshing resonance frequencies ω_{S}, providing for a -4 slope. The sloshing resonance frequency ω_{S} may be lower than the Helmholz resonance frequency ω_{HR}, as the larger hydraulic mass of the fluid between the silencers is involved. The sloshing resonance frequency ω_{S} may be dimensioned to be below a disturbance frequency band in which disturbances are to be suppressed, enabling to significantly suppress a propagation of the disturbances as a result of the -2 slope per silencer pair. Tuning the hydraulic mass in-between silencers (***M_hyd***), hydraulic mass in a conduit between the duct and the silencer (***M_hyd***), or the silencer compliancy (***K_hyd*** ) allows to optimize the suppression behavior. Dimensioning the hydraulic mass between the silencers and the silencer compliancy to provide that the sloshing frequencies of the silencer pairs are below the disturbance frequency band may allow to obtain the -2 slope per silencer pair in the disturbance frequency band enabing to suppress the disturbances in the disturbance frequency band by the -2 slope per silencer pair.

In an embodiment, the resonator is a series resonator. The series resonator enables to make use of the mass of the thermal conditioning fluid between the two silencers, hence enabling to use mass that is present in the fluid duct. As a result, no additional mass is required, resulting in little added weight.

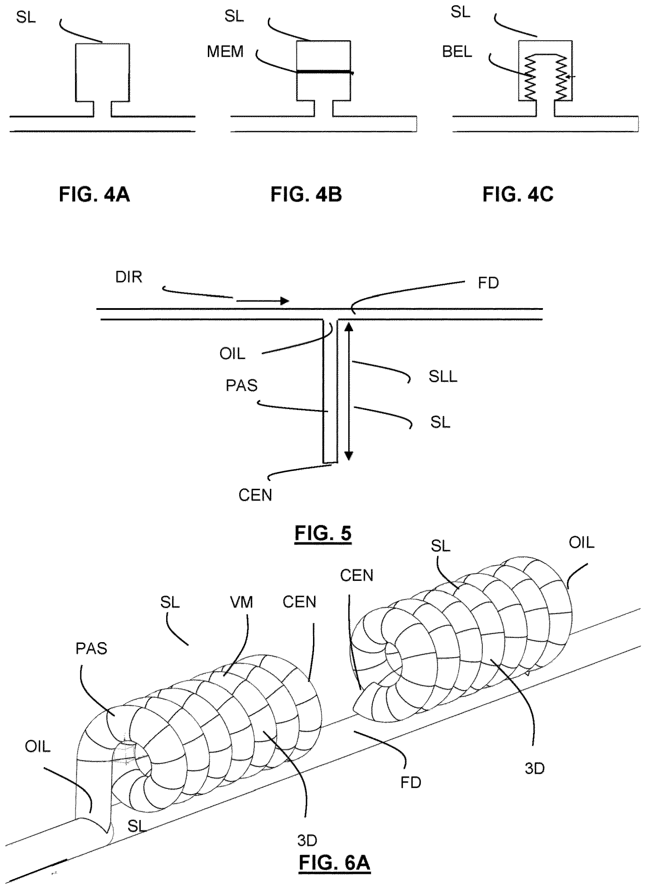

Figures 4A - 4C schematically depict three different embodiments of a silencer. The silencer SL as depicted in Figure 4A is formed by an interior space, which is partly filled with a gas, which gas may refrain from dissolving in the thermal conditioning fluid. A resilience may be formed by the gas when pressurized by the thermal conditioning fluid.

Figure 4B depicts a silencer SL comprising a membrane MEM which divides the interior space of the silencer into a part e.g. filled with a gas and a part filled with thermal conditioning fluid. A resiliency of the membrane, possibly in combination with a pressurizing of the gas, provides for a resiliency of the thermal conditioning fluid interacting with the silencer.

Figure 4C depicts a silencer SL comprising a membrane shaped as a bellow BEL which divides the interior space of the silencer into a part e.g. filled with a gas and a part filled with the thermal conditioning fluid. A resiliency of the membrane shaped as a bellow, possibly in combination with a pressurizing of the gas, provides for a resiliency of the thermal conditioning fluid interacting with the silencer.

The present invention elaborates on the above developments, and seeks to provide a further embodiment of a silencer.

Figure 5 depicts a highly schematic view of an embodiment of a silencer SL. The silencer is based on a principle of a quarter wave tube, comprising a tube having a length substantially equal to a quarter of a primary wavelength of a vibration to be silenced. The silencer comprises an open inlet OIL. The open inlet comprises an inlet opening configured to supply thermal conditioning fluid into the silencer. The inlet is configured to be connected to the thermal conditioning fluid duct FD to enable a communication of the thermal conditioning fluid between the thermal conditioning fluid duct and the silencer. The silencer further comprises a closed end CEN. The closed end of the silencer is configured to reflect the acoustic wave in the thermal conditioning fluid. Between the open inlet and the closed end, a silencer duct is provided which forms a thermal conditioning fluid passage PAS between the open inlet and the closed end. In use, the passage is filled with thermal conditioning fluid extending from the open inlet to the closed end. The open inlet of the silencer is connected to the thermal conditioning fluid duct FD which may provide the thermal conditioning fluid to the object to be conditioned or may discharge the thermal conditioning fluid from the object to the conditioned. A flow of the thermal conditioning fluid in the thermal conditioning fluid duct may thus pass along the open inlet of the silencer. The thermal conditioning fluid duct, also identified as fluid duct, may be formed by any fluid duct, such as a tube, as hose, a channel, a bore, or any combination thereof. For example, the thermal conditioning fluid duct may comprise a fluid flow passage in or on the object, e.g. a fluid channel in the object or a fluid duct on the object, e.g. at a rear side of the object. As another example, the fluid duct may comprise a fluid flow passage in or on the object in combination with a fluid supply duct to supply the thermal conditioning fluid to the object and a fluid discharging duct to discharge the thermal conditioning fluid from the object.

The thermal conditioning fluid may flow through the thermal conditioning fluid duct FD, e.g. in a flow direction DIR. A disturbance, such as a vibration, e.g. an acoustic wave, may propagate along the thermal conditioning fluid duct, and may e.g. interact with the object to be thermally conditioned. The vibration may e.g. propagate through the thermal conditioning fluid. The silencer may serve to silence the vibration, e.g. at least reducing an amplitude of the vibration. The vibration may e.g. be a disturbance wave at a disturbance frequency. The vibration, i.e. the disturbance wave, may travel via the thermal conditioning fluid to the silencer, where it enters the silencer at the open inlet and travels along the thermal conditioning fluid passage to the closed end. At the closed end, the vibration is reflected back into the passage. According to the quarter wave principle, the reflected wave at least partly cancels the incoming wave depending on a wavelength of the wave, in relation to a length SLL of the passage. In case the length of the passage, i.e. from the open inlet to the closed end, has a length equal to a quarter of the wavelength of the vibration, the reflected wave cancels, or at least partly cancels, the incoming wave. The quarter wavelength silencer hence has as advantage that the reflected wave silences the incoming wave to a large extent, thus providing for a high degree of attenuation. Moreover, the attenuation is to a large extent dependent on reflection, hence being less dependent in e.g. a compliancy of a membrane, which membrane or other compliant member could be subject to aging, etc. On the other hand, the quarter wavelength attenuation is highly dependent on a wavelength, i.e. a frequency of the vibration that is to be attenuated, more particular, the attenuation will be effective in case the passage length is substantially a quarter wavelength, three quarters of a wavelength, etc., hence effective for specific wavelengths, thus specific frequencies.

In the thermal conditioning system, use may be made of a thermal conditioning fluid, such as a thermal conditioning liquid, such as water, a water based solution, a liquid mixture comprising water. On the one hand, such a thermal conditioning liquid may provide for a high exchange of thermal energy for cooling and/or heating. On the other hand, a propagation velocity of the disturbances in the liquid may be high. As a consequence of the high propagation velocity, at a given disturbance frequency, a wavelength of the disturbance propagating through the thermal conditioning fluid may be high. As a consequence, in order to be able to benefit from the quarter wavelength attenuation, a length of the passage is required to be long.

Figure 6A depicts a perspective view of a fluid duct FD with dual silencers according to an embodiment of the invention. Likewise to the silencer described with reference to Figure 5, the silencers are based on a principle of a quarter wave tube, comprising a tube having a length substantially equal to a quarter of a primary wavelength of a vibration to be silenced. The silencers each comprise an open inlet OIL. The open inlet comprises an inlet opening configured to supply thermal conditioning fluid into the silencer. The inlet is configured to be connected to the thermal conditioning fluid duct FD to enable a communication of the thermal conditioning fluid between the thermal conditioning fluid duct and the silencer. The silencers further comprise a closed end CEN. The closed end of the silencer is configured to reflect the acoustic wave in the thermal conditioning fluid. Between the open inlet and the closed end, a silencer duct is provided which forms a thermal conditioning fluid passage PAS between the open inlet and the closed end. In use, the passage is filled with thermal conditioning fluid extending from the open inlet to the closed end. The open inlet of each silencer is connected to the thermal conditioning fluid duct FD which may provide the thermal conditioning fluid to the object to be conditioned or may discharge the thermal conditioning fluid from the object to the conditioned. A flow of the thermal conditioning fluid in the thermal conditioning fluid duct may thus pass along the open inlets of the silencers.

The inventors have devised that the quarter wavelength silencer may be used and formed in a relatively compact outline, i.e. in relatively compact dimensions, in that the silencer duct comprises a viscoelastic material VM. The viscoelastic material may promote a reduction of the propagation velocity of the disturbance, i.e. the vibration, through the thermal conditioning fluid, in particular in case the thermal conditioning fluid comprises a thermal conditioning liquid, such as water, a water based solution, or a liquid mixture comprising water, the propagation velocity of an acoustic wave in the thermal conditioning fluid may be reduced, causing a wavelength to be reduced, as a result reducing a quarter wavelength as may be required for the quarter wavelength silencing.

Moreover, in order to be able to use the quarter wavelength silencer in a relatively compact outline, the inventors have devised that the silencer duct has a three dimensional shape 3D configured to provide at least one revolution in the thermal conditioning fluid passage. The at least one revolution may be understood as a revolution around a main axis along which the silencer extends, i.e. an axis from the open inlet to the closed end. In the direction of the main axis along which the silencer extends, i.e. the direction from the open inlet to the closed end, a length of the silencer may be reduced. The at least one revolution may provide for a smooth flow of the thermal conditioning fluid, in particular thermal conditioning liquid, through the passage, as sharp bends, sharp edges, etc. (which could otherwise result in turbulence, etc., may be avoided.

The following advantages may be achieved using the quarter wave silencer according to the invention:
No fatigue: a change of properties of the silencer due to fatigue of a membrane/bellow may be avoided.
Reliability: a reliability concern of gas silencers due to leakage/failure may be fully erased. The quarter wavelength silencer basically has no component to fail or require any maintenance/replacement. Thus, can easily operate for an entire machine lifetime.
Volume saving and layout flexibility: because the only design parameter for the quarter wavelength silencer is the total length of the device, therefore, it can be designed in any shape to benefit from any left-over/remaining/dead spaces with limited accessibility in the scanner. The shape can be flexibly formed to even benefit from multiple available smaller volumes, which would therefore, provide layout flexibility.
No issue with initial filling and robust performance: any issues regarding initial gas filling of the gas silencers and the vulnerability to changes in operational pressure ay be avoided.
Commonality and simplicity in design: the design of The quarter wavelength silencer may be very simple. The simplicity in design also makes it flexible for design changes and product upgrades, as the only parameter to adjust will be the total length.

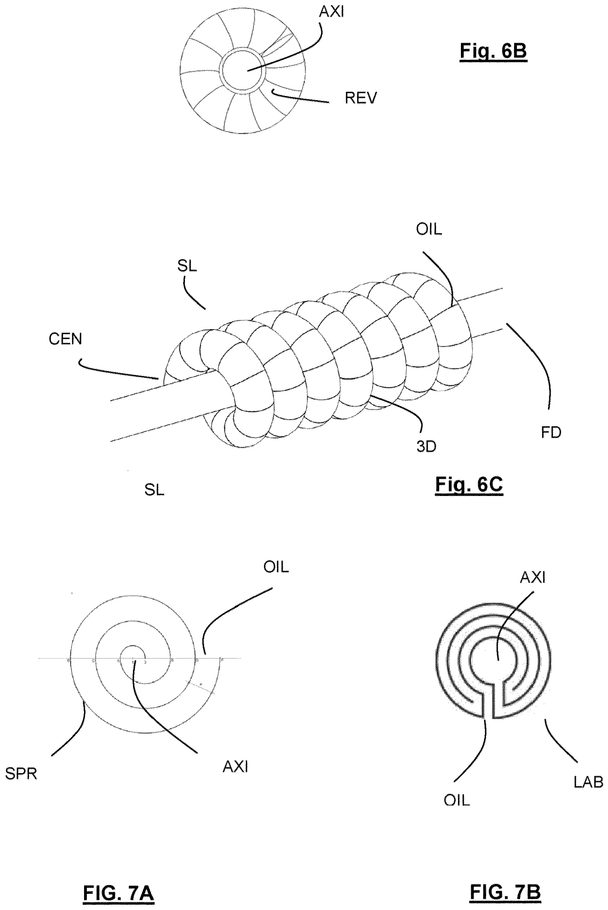

The three dimensional shape may comprise at least one revolution. Figure 6B depicts another view of the silencer in accordance with Figure 6A, namely a view from the direction of the open inlet towards the closed end, depicting the revolution REV around the axis AXI from the opening inlet to the closed end.

Figure 6C depicts another embodiment of a silencer which wherein the revolution of the silencer SL is wound about the thermal conditioning fluid duct FD.

In an embodiment, the geometric shape comprises at least one of a helix, a labyrinth and a spiral. For example, the geometric shape comprises a helix, such as a circular helix having a constant diameter, such as depicted in Figures 6A and 6B. A pitch of the helix may be equal to a cross sectional outer diameter of the passage, thus providing that the revolutions of the helix are adjacent to each other, hence contributing to a compact overall dimension of the silencer. The helix may be a cylindrical helix, providing an efficient cylindrical outer form factor of the passage or part of the passage. As another example, as depicted in Figure 7A, the geometric shape comprises a spiral, the spiral may be understood as a curve which emanates from a point, moving farther away as it revolves around the point. The spiral forms a passage that extends from the open inlet OIL to the closed end at the axis AXI around which the spiral spirals. The spiral may provide a relatively long length of passage in a compact outer form factor, namely a circular "disk shaped" form factor. Similarly to the helix, the spiral may provide a smooth shape largely avoiding bends, edges, etc. hence avoiding adverse effects due to bends or edges, etc.. As yet another example, as depicted in Figure 7B, the geometric shape comprises a labyrinth forming a passage from the open inlet OIL to the closed end at the axis AXI. Likewise to the spiral, the labyrinth may provide a relatively long length of passage in a similarly shaped, compact outer form factor.

According to the quarter wave principle, the closed end is configured to reflect the pressure wave with an anti-phase. For example, the closed end comprises a flat wall having a flat endsurface that closes the passage. For example, the flat wall is stiff to contribute to a reflective character to reflect the wave instead of absorbing it.

The viscoelastic material may comprise any type of viscoelastic material. In an embodiment, he viscoelastic material comprises a polytetrafluoroethylene, PTFE, i.e. a synthetic fluoropolymer of tetrafluoroethylene. In another embodiment, the viscoelastic material comprises a polyurethane, PUR, i.e. a polymer composed of organic units joined by carbamate (urethane) links. As an example of a polyurethane, the viscoelastic material may comprise a PUN-H polyurethane. In yet another embodiment, the viscoelastic material comprises a terpolymer, such as THV, comprising tetrafluoroethylene, hexafluoropropylene and vinylidene fluoride. In still yet another embodiment, the viscoelastic material comprises a fluoroelastomer, i.e. a fluorinated, carbon-based synthetic rubber.

In an embodiment, the target frequency at which the silencer silences an incoming wave, is determined by an overall path length of the passage. The overall path length of the passage may be determined by at least one of a length of the at least one revolution, a number of revolutions and a radius of the at least one revolution.

The silencer as described above may be comprised in a thermal conditioning system configured to thermally condition an object. The thermal conditioning system comprises a thermal conditioning fluid duct configured to be connected to the object and configured to provide a flow of the thermal conditioning fluid to the object. The thermal conditioning fluid duct comprises at least one silencer such as described with reference to Figure 6A and 6B, Figure 7A or Figure 7B.

For example, in order to suppress at least two target frequencies, the thermal conditioning fluid duct comprises at least two silencers, spaced apart along the thermal conditioning fluid duct, wherein the target frequencies of the at least two silencers differ from each other. Thus, each one of the at least two silencers is configured to silence at a respective target frequency. Accordingly, the at least two silencers may differ in at least one of a length of the at least one revolution, a number of revolutions and a radius of the at least one revolution to provide different lengths of the passages of the at least two silencers, hence different target frequencies. The silencers may be arranged along the thermal conditioning fluid duct in a similar way as described with reference to Figure 2A and 2B

In order to further attenuate vibrations in the thermal conditioning duct, at least a part of the thermal conditioning fluid duct to which the at least one silencer is connected, comprises a viscoelastic material, such as a same viscoelastic material as comprised in a wall of the passage of the silencer.

The thermal conditioning system may be comprised in a lithographic apparatus. The lithographic apparatus comprises an object and the thermal conditioning system to thermally condition the object. For example, the object may be one of a projection system mirror, a substrate table, a support to support a pattering device, a force frame and a sensor frame of the lithographic apparatus.

A method of thermally conditioning an object of a lithographic apparatus comprises providing a flow of a thermal conditioning fluid via a thermal conditioning fluid duct to the object. The method further comprises silencing an acoustic vibration in the thermal conditioning fluid by the silencer such as described above.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquidcrystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A silencer configured to silence an acoustic wave in a thermal conditioning fluid in a thermal conditioning fluid duct, the silencer comprising
an open inlet configured to be connected to the thermal conditioning fluid duct to be in fluid communication with the thermal conditioning fluid in the thermal conditioning fluid duct,
a closed end configured to reflect the acoustic wave in the thermal conditioning fluid, and
a silencer duct forming a thermal conditioning fluid passage between the open inlet and the closed end,
wherein the silencer duct has a three dimensional shape configured to provide at least one revolution in the thermal conditioning fluid passage,
wherein the silencer is configured to silence the acoustic wave at a target frequency, and
wherein the silencer duct comprises a viscoelastic material.

2. The silencer according to claim 1, wherein the three dimensional shape comprises one of a helix, a labyrinth and a spiral.

3. The silencer according to claim 1 or 2, wherein the closed end is configured to reflect the pressure wave with an anti-phase.

4. The silencer according to any one of the preceding claims, wherein the viscoelastic material comprises at least one of:
- a polytetrafluoroethylene,
- a polyurethane,
- a terpolymer comprising tetrafluoroethylene, hexafluoropropylene and vinylidene fluoride, and
- a fluoroelastomer.

5. The silencer according to any one of the preceding claims, wherein the target frequency is determined by at least one of a length of the at least one revolution, a number of revolutions and a radius of the at least one revolution.

6. A thermal conditioning system configured to thermally condition an object, wherein the thermal conditioning system comprises a thermal conditioning fluid duct configured to be connected to the object and configured to provide a flow of the thermal conditioning fluid to the object, wherein the thermal conditioning fluid duct comprises at least one silencer according to any one of the preceding claims.

7. The thermal conditioning system according to claim 6, wherein the thermal conditioning fluid duct comprising at least two silencers, spaced apart along the thermal conditioning fluid duct, wherein the target frequencies of the at least two silencers differ from each other.

8. The thermal conditioning system according to claim 7, wherein the at least two silencers differ in at least one of a length of the at least one revolution, a number of revolutions and a radius of the at least one revolution.

9. The thermal conditioning system according to any one of claims 6 - 8, wherein at least a part of the thermal conditioning fluid duct to which the at least one silencer is connected, comprises a viscoelastic material.

10. A lithographic apparatus comprising an object and a thermal conditioning system according to any one of claims 6 to 9 to thermally condition the object.

11. The lithographic apparatus according to claim 10, wherein the object is one of a projection system mirror, a substrate table, a support to support a pattering device, a force frame and a sensor frame of the lithographic apparatus.

12. A method of thermally conditioning an object of a lithographic apparatus, comprising providing a flow of a thermal conditioning fluid via a thermal conditioning fluid duct to the object, the method comprising silencing an acoustic vibration in the thermal conditioning fluid by a silencer according to any one of claims 1-5.
